# EUROPEAN PATENT APPLICATION

(11) **EP 4 404 267 A1**
(43) Date of publication of application: **24.07.2024**
(21) Application number: 22885212.5
(22) Date of filing: 19.07.2022
(51) Int. Cl.: H01L 29/06

(54) **SEMICONDUCTOR DEVICE AND INTEGRATED CIRCUIT**

(30) Priority: 29.10.2021 CN 202111267904
(71) Applicant: Huawei Digital Power Technologies Co., Ltd., Shenzhen, Guangdong 518043 (CN)
(72) Inventor: HU, Fei, Shenzhen, Guangdong 518043 (CN); TANG, Longgu, Shenzhen, Guangdong 518043 (CN); GAO, Yunbin, Shenzhen, Guangdong 518043 (CN); GAO, Bo, Shenzhen, Guangdong 518043 (CN)
(74) Representative: Maiwald GmbH
(86) International application number: PCT/CN2022/106506
(87) International publication number: WO 2023/071308

(57) **Abstract**

This application discloses a semiconductor device and an integrated circuit. The semiconductor device includes an N-type semiconductor substrate, a drift layer, a semiconductor layer, a first trench located in the semiconductor layer, a gate located in the first trench, a P-well, a source region, and an N-type second semiconductor region that are located in the semiconductor layer, a source, and a drain. The drift layer includes an N-type column region and a P-type column region that are disposed in parallel and alternately. In the semiconductor device, an electrode is further disposed below the gate, a P-type first semiconductor region is disposed at the bottom of the first trench, the first semiconductor region is in contact with the electrode and the P-type column region located below the gate, and the electrode is electrically connected to the source. In this way, the P-type column region located below the gate may be connected to the source through the electrode, and good electrical contact is implemented between the electrode and the first semiconductor region, thereby implementing a grounding function.

## Description

### CROSS-REFERENCE TO RELATED APPLICATIONS

This application claims priority to Chinese Patent Application No. 202111267904.7, filed with the China National Intellectual Property Administration on October 29, 2021 and entitled "SEMICONDUCTOR DEVICE AND INTEGRATED CIRCUIT", which is incorporated herein by reference in its entirety.

### TECHNICAL FIELD

This application relates to the field of semiconductor technologies, and in particular, to a semiconductor device and an integrated circuit.

### BACKGROUND

Compared with the Si material, the SiC material has advantages such as a wide band gap, a high critical breakdown electric field, a high thermal conductivity, and a high electron saturation drift speed. Compared with an insulated gate bipolar transistor (Insulated Gate Bipolar Transistor, IGBT) made of the Si material, a metal-oxide-semiconductor field-effect transistor (Metal-Oxide-Semiconductor Field-Effect Transistor, MOSFET) made of the SiC material has features such as a high breakdown voltage and a low on-voltage drop. In addition, unipolar conductivity enables the SiC MOSFET to have a higher switching speed, a lower conduction loss, and a lower switching loss than the Si IGBT. Therefore, the SiC MOSFET has replaced the Si IGBT in some fields. However, as a voltage level increases, a drift region resistance of the SiC MOSFET continuously increases, and consequently, an on resistance of the device significantly increases.

To reduce an on resistance of the SiC MOSFET, a super junction (Super junction, SJ) drift region technology may be used, that is, an N-type column region and a P-type column region that are alternately arranged are manufactured in the drift region of the SiC MOSFET, so that a theoretical limit between an on resistance of a device and a breakdown voltage is broken through by using a charge coupling principle, thereby further reducing the on resistance of the SiC MOSFET, improving performance of the device, and reducing a chip loss.

However, in the SiC MOSFET using the super junction drift region technology, to implement a charge coupling principle, the P-type column region in the drift region needs to be grounded (connected to a zero potential), so that the P-type column region and the N-type column region are mutually exhausted to form a transverse electric field, thereby giving full play to a structural advantage of the super junction drift region. Therefore, how to ground the P-type column region in the drift region is a technical problem that needs to be resolved by a person skilled in the art.

### SUMMARY

This application provides a semiconductor device and an integrated circuit, to implement grounding of a P-type column region in a super junction drift region in a SiC MOSFET.

According to a first aspect, this application provides a semiconductor device, where the semiconductor device may include an N-type semiconductor substrate (N++), a drift layer, a semiconductor layer, a gate, a source, a drain, a gate insulating film, and an electrode. The drift layer is disposed on the semiconductor substrate, and the drift layer includes an N-type column region (N) and a P-type column region (P) that are alternately and repeatedly disposed in parallel. Herein, "alternately and repeatedly disposed" means that the N-type column region (N) and the P-type column region (P) are disposed in parallel in a manner of "N, P, N, P..." or "P, N, P, N...". The semiconductor layer is disposed above the drift layer, a first trench used to dispose a gate is disposed in the semiconductor layer, and the first trench is disposed in a region corresponding to the P-type column region. The gate is disposed in the first trench and separated by the gate insulating film. The electrode is disposed in the first trench and located between the gate and the P-type column region, a gate insulating film is spaced between the electrode and the gate, and the electrode is electrically connected to the source. The semiconductor layer may include a first semiconductor region (P+) located at the bottom of the first trench, and a P-well, a source region (N+), and a second semiconductor region (N) that are located on a side wall of the first trench. The first semiconductor region is a P-type semiconductor region, the second semiconductor region is an N-type semiconductor region, the source region is located above the P-well, the second semiconductor region is located between the P-well and the N-type column region, the first semiconductor region is located between the electrode and the P-type column region, the first semiconductor region is in contact with the electrode and the P-type column region, a doping density of the first semiconductor region is higher than a doping density of the P-type column region, and the first semiconductor region is used to electrically connect the electrode to the P-type column region. The source is disposed above the semiconductor layer, and the source is in contact with the source region and electrically connected to the electrode. The drain is disposed on a side that is of the semiconductor substrate and that is away from the drift layer.

In the semiconductor device provided in this embodiment of this application, the electrode is disposed below the gate, the P-type first semiconductor region is disposed at the bottom of the first trench, the first semiconductor region is in contact with the electrode and the P-type column region located below the gate, and the electrode is electrically connected to the source. In this way, the P-type column region located below the gate may be connected to the source through the electrode, and good electrical contact is implemented between the electrode and the first semiconductor region, thereby implementing a grounding function. In addition, because both the electrode and the first semiconductor region are located below the gate, compared with a related technology, this does not sacrifice a MOS conductive channel on the side wall of the first trench, that is, the conductive channel is added, so that an on resistance of the device can be reduced. In addition, the grounded electrode can shield a gate-drain capacitance, thereby reducing a Miller capacitance of the device and improving a switching speed. In addition, the grounded electrode can further effectively reduce an electric field in the gate insulating film located at the bottom of the first trench, thereby improving working robustness of the device.

In this application, the first semiconductor region (P+), the P-well, the source region (N+), the second semiconductor region (N), and the third semiconductor region (P++), the fourth semiconductor region (P+), and the fifth semiconductor region (P+) that are located in the semiconductor layer may be formed by doping the semiconductor layer. The source region (N+) is an N-type semiconductor region, the P-well is a P-type semiconductor region, the N-type semiconductor region is mainly doped with an N-type impurity such as nitrogen (N), phosphorus (P), or arsenic (As), and the P-type semiconductor region is mainly doped with a P-type impurity such as aluminum (Al), boron (B), or gallium (Ga). The P-well is a P-type impurity that is doped in the N-type semiconductor layer with sufficient density to neutralize the N-type semiconductor layer and allow the N-type semiconductor layer to have a P-type feature.

It should be noted that, in this application, in a layer and an area with a prefix of N, it indicates that an electron is a majority carrier, and in a layer and an area with a prefix of P, it indicates that an electron hole is a majority carrier. In addition, "+" marked with "N" or "P" indicates that the doping density is higher than that of the layer or region not marked with "+", and a larger quantity of "+" indicates a higher doping density. N or P including the same quantity of "+" represents similar doping densities and is not limited to a same doping density.

In addition, it should be further noted that, in this application, a comparison between doping densities of two regions is merely a comparison between densities of impurities doped in the two regions; and neither a component of the impurity nor a substrate used for doping the impurity is limited, that is, the components of the impurity may be the same or may be different, and materials of the substrate used for doping the impurity may be the same or may be different.

A thickness of the electrode is not limited in this application, and may be set based on a requirement of the device.

In this application, a material of the electrode may be heavily doped polycrystalline silicon, or may be another material having a good conductive feature, such as metal. This is not limited herein.

According to the semiconductor device provided in this embodiment of this application, the electrode is mainly disposed for the P-type column region located below the gate. During specific implementation, in the drift layer, only a part of the P-type column region is located below the gate, and another part of the P-type column region is not disposed below the gate. The part that is of the P-type column region and that is located below the gate is a first P-type column region, and the remaining part of the P-type column region is a second P-type column region. A manner of electrically connecting the second P-type column region to the source is not limited in this application.

For example, the semiconductor device may further include: a third semiconductor region (P++) disposed in the semiconductor layer, where the third semiconductor region (P++) is a P-type semiconductor region, and the third semiconductor region is located between the second P-type column region and the source; the third semiconductor region is in contact with the source and the second P-type column region; and a doping density of the third semiconductor region is higher than a doping density of the second P-type column region. In this way, the second P-type column region is electrically connected to the source through the third semiconductor region.

During specific implementation, to enable the third semiconductor region in the semiconductor layer to be in contact with both the second P-type column region and the source, a thickness of the third semiconductor region needs to be the same as a thickness of the semiconductor layer, and consequently, a process difficulty of the third semiconductor region is increased.

Therefore, to reduce a process difficulty, in an embodiment, the semiconductor device may further include: a fourth semiconductor region (P+) disposed in the semiconductor layer, where the fourth semiconductor region is a P-type semiconductor region, and the fourth semiconductor region is located between the second P-type column region and the third semiconductor region; the fourth semiconductor region is in contact with the third semiconductor region and the second P-type column region; and a doping density of the fourth semiconductor region is lower than the doping density of the third semiconductor region and higher than a doping density of the P-type column region. In this way, during preparation, the fourth semiconductor region may be first formed, and then the third semiconductor region is formed, so that the process difficulty can be reduced.

During specific implementation, the doping density of the fourth semiconductor region may be close to the doping density of the first semiconductor region, but is not limited to the same doping density.

For example, the doping density of the fourth semiconductor region is the same as the doping density of the first semiconductor region. In this way, during preparation, the fourth semiconductor region and the first semiconductor region may be prepared at the same time, thereby simplifying process steps.

In another embodiment, the semiconductor device further includes a second trench disposed in the semiconductor layer, the second trench is filled with the source, and the third semiconductor region includes a first extension part located at the bottom of the second trench and a second extension part located on a side wall of the second trench. In this way, the thickness of the third semiconductor region can be reduced by disposing the second trench, so that the process difficulty can be reduced.

In this application, a P-well and a source region are disposed on both sides of the gate, to ensure that MOS conductive channels exist on both sides of the gate of the SiC MOSFET.

A shape of the first trench is not limited in this application. For example, a cross section of the first trench in a direction perpendicular to the semiconductor substrate is rectangular, or a cross section of the first trench in a direction perpendicular to the semiconductor substrate is trapezoidal, and a longer distance between the cross section of the first trench in a direction parallel to the semiconductor substrate and the semiconductor substrate indicates a larger area of the cross section, that is, an area of a top surface (a cross section located on a side far away from the semiconductor substrate) of the first trench is larger than an area of a bottom surface (a cross section located on a side close to the semiconductor substrate) of the first trench.

To improve electrical contact between the electrode and the first P-type column region, the first semiconductor region may be located in a first extension part at the bottom of the first trench and a second extension part on a side wall on one side of the first trench. In this way, when the semiconductor device includes a plurality of gates, a part of the first semiconductor region may be set to include the first extension part and the second extension part, that is, only a MOS conductive channel on one side of each of some gates is sacrificed. Compared with the related technology in which a MOS conductive channel on one side of each gate needs to be sacrificed, this improves electrical contact between the electrode and the first P-type column region, and reduces the on resistance of the semiconductor device.

During specific implementation, in the semiconductor device provided in this embodiment of this application, the semiconductor layer may include a plurality of first trenches. To improve electrical contact between the electrode and the first P-type column region, the semiconductor layer further includes at least one second trench, and the second trench is located between two adjacent first trenches. The semiconductor layer further includes a P-type fifth semiconductor region (P+) located at the bottom of the second trench, and a doping density of the fifth semiconductor region is higher than the doping density of the P-type column region. The fifth semiconductor region is in contact with the source and the P-type column region.

During specific implementation, the doping density of the fifth semiconductor region may be close to the doping density of the first semiconductor region, but is not limited to the same doping density.

For example, the doping density of the fifth semiconductor region is the same as the doping density of the first semiconductor region. In this way, during preparation, the fifth semiconductor region and the first semiconductor region may be prepared at the same time, thereby simplifying process steps.

For example, the fifth semiconductor region is connected to the first semiconductor region adjacent to the fifth semiconductor region, that is, the fifth semiconductor region and the first semiconductor region are of an integrated structure.

Further, to increase a contact area between the source and the fifth semiconductor region, the second trench is connected to two first trenches adjacent to the second trench. That is, it is equivalent to connecting two adjacent first trenches and the second trench located between the two adjacent first trenches, so that the two gates and a part of the source are disposed in a same trench, where the gate and the source are isolated by a gate insulating film.

According to a second aspect, an integrated circuit is provided, where the integrated circuit includes a circuit board, and the semiconductor device disposed on the circuit board according to any one of the first aspect or the implementations of the first aspect.

For technical effects that can be achieved in the second aspect, refer to descriptions of the technical effects that can be achieved in any possible design of the first aspect. Details are not described herein again.

### BRIEF DESCRIPTION OF DRAWINGS

FIG. 1 is a schematic diagram of a structure of a SiC MOSFET;
FIG. 2 is a schematic diagram of a structure of a SiC SJ-MOSFET in a related technology;
FIG. 3 is a schematic diagram of a structure of a semiconductor device according to an embodiment of this application;
FIG. 4 is a schematic diagram of a structure of another semiconductor device according to an embodiment of this application;
FIG. 5 is a schematic diagram of a structure of another semiconductor device according to an embodiment of this application;
FIG. 6 is a schematic diagram of a structure of another semiconductor device according to an embodiment of this application;
FIG. 7 is a schematic diagram of a structure of another semiconductor device according to an embodiment of this application;
FIG. 8 is a schematic diagram of a structure of another semiconductor device according to an embodiment of this application; and
FIG. 9 is a schematic diagram of a structure of another semiconductor device according to an embodiment of this application.

### DESCRIPTION OF EMBODIMENTS

To make the objectives, technical solutions, and advantages of this application clearer, the following further describes this application in detail with reference to the accompanying drawings. However, example embodiments may be implemented in a plurality of forms and should not be construed as being limited to embodiments described herein. On the contrary, these embodiments are provided such that this application is more comprehensive and complete and fully conveys the concept of the example embodiments to a person skilled in the art. Identical reference numerals in the accompanying drawings denote identical or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

It should be noted that specific details are described below to provide a thorough understanding of this application. However, this application can be implemented in numerous other manners different from those described herein, and a person skilled in the art can make similar inferences without departing from the connotation of this application. Therefore, this application is not limited to the specific implementations disclosed below. Example implementations of this application are subsequently described in this specification, but the description is intended to describe general principles of this application and is not intended to limit the scope of this application. The protection scope of this application is subject to the appended claims.

For ease of understanding of a gate-all-around transistor provided in an embodiment of this application, the following first describes an application scenario of the gate-all-around transistor.

Compared with the Si material, the SiC material has advantages such as a wide band gap, a high critical breakdown electric field, a high thermal conductivity, and a high electron saturation drift speed. Compared with an insulated gate bipolar transistor (Insulated Gate Bipolar Transistor, IGBT) made of the Si material, a metal-oxide-semiconductor field-effect transistor (Metal-Oxide-Semiconductor Field-Effect Transistor, MOSFET) made of the SiC material has features such as a high breakdown voltage and a low on-voltage drop. In addition, unipolar conductivity enables the SiC MOSFET to have a higher switching speed, a lower conduction loss, and a lower switching loss than the Si IGBT. Therefore, the SiC MOSFET has been widely applied in fields such as a switch-mode regulated power supply, a power amplifier, an in-vehicle power supply of an electric vehicle, a photovoltaic inverter, a server power supply, and rail transportation.

It should be noted that, in this application, in a layer and a region with a prefix of N or P, it indicates that an electron or a hole is a majority carrier. In addition, "+" marked with "N" or "P" indicates that the doping density is higher than that of the layer or region not marked with "+", and a larger quantity of "+" indicates a higher doping density. N or P including the same quantity of "+" represents similar doping densities and is not limited to a same doping density.

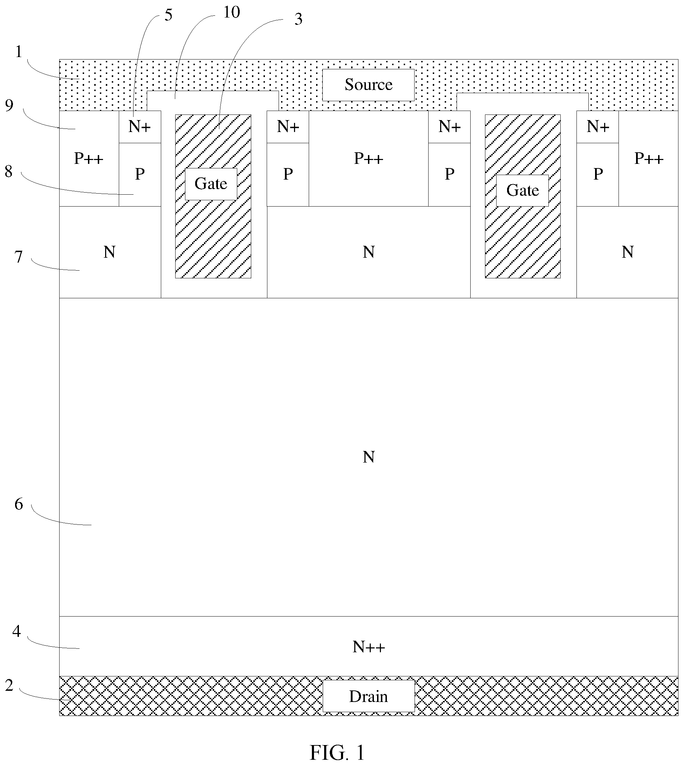

FIG. 1 is a schematic diagram of a structure of a SiC MOSFET. The SiC MOSFET includes: a source 1, a drain 2, a gate 3, a drain region (N++) 4, a source region (N+) 5, a drift region (N) 6, an N-type first semiconductor region (N) 7, a P-well (P) 8, a P-type first semiconductor region (P++) 9, and a gate insulating film 10. The drift region 6 is an N-type semiconductor region, and is mainly used to carry a high voltage. The N-type first semiconductor region 7 is mainly used to reduce an on resistance of the SiC MOSFET, and a doping density of the N-type first semiconductor region 7 is generally higher than a doping density of the drift region 6. The P-type first semiconductor region 9 allows the P-well 8 to be in contact with the source 1, so that the P-well 8 is short-circuited to a PN junction of the source region 5, to prevent the PN junction from being turned on.

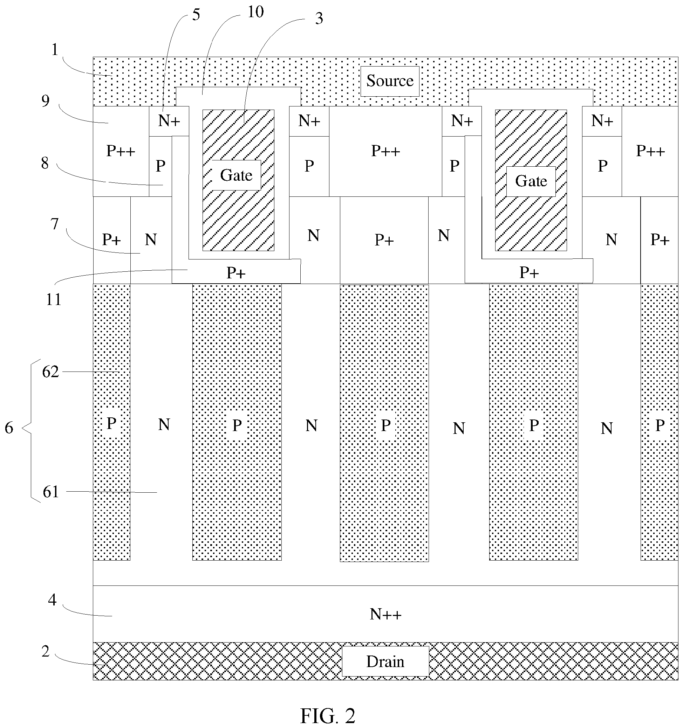

However, as a voltage level increases, a drift region resistance of the SiC MOSFET continuously increases, and consequently, an on resistance of the device significantly increases. To reduce the on resistance of the SiC MOSFET, a super junction drift region technology may be used. As shown in FIG. 2, in the SiC MOSFET, there are alternately arranged N-type column regions 61 and P-type column regions 62 in the drift region, so that a theoretical limit between the on resistance of the device and the breakdown voltage is broken through by using a charge coupling principle, thereby further reducing the on resistance of the SiC MOSFET, improving performance of the device, and reducing a chip loss. However, in the SiC MOSFET, to implement a charge coupling principle, the P-type column region 62 in the drift region needs to be grounded (connected to a zero potential). For the P-type column region 62 located below the gate 3, a P-type second semiconductor region 11 is disposed at the bottom of the trench of the gate 3 and a side wall on one side, so that the P-type column region 62 and the N-type column region 61 are mutually exhausted to form a transverse electric field, thereby giving full play to a structural advantage of the super junction drift region.

Still refer to FIG. 2. In the SiC MOSFET, the MOS conductive channels that can be originally generated on both sides of the trench of the gate 3 cannot be formed because of the P-type second semiconductor region 11, that is, the MOS conductive channel can be generated only on the side wall on one side. Therefore, nearly half of the MOS conductive channels are sacrificed, and an ampacity of the device is reduced and the on resistance is increased.

Therefore, embodiments of this application provide a semiconductor device and an integrated circuit that can reduce an on resistance of a device. The following describes the semiconductor device and the integrated circuit in detail with reference to specific accompanying drawings and embodiments.

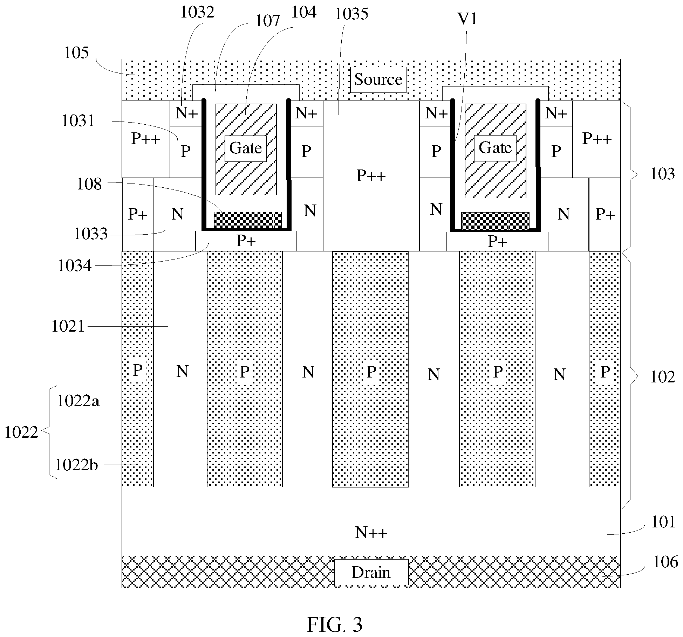

FIG. 3 is a schematic diagram of a structure of a semiconductor device according to an embodiment of this application. The semiconductor device is a SiC SJ-MOSFET, and two gates are used as an example for illustration in FIG. 3. Specifically, the semiconductor device may include: an N-type semiconductor substrate (N++) 101, a drift layer 102, a semiconductor layer 103, a gate 104, a source 105, a drain 106, a gate insulating film 107, and an electrode 108. The drift layer 102 is disposed on the semiconductor substrate 101, and the drift layer 102 includes an N-type column region (N) 1021 and a P-type column region (P) 1022 that are alternately and repeatedly disposed in parallel. Herein, "alternately and repeatedly disposed" means that the N-type column region (N) and the P-type column region (P) are disposed in parallel in a manner of "N, P, N, P..." or "P, N, P, N...". The semiconductor layer 103 is disposed above the drift layer 102; and a first trench V1 used to dispose the gate 104 is disposed in the semiconductor layer 103, and the first trench V1 is disposed in a region corresponding to the P-type column region 1022. The gate 104 is disposed in the first trench V1 and separated by the gate insulating film 107. The electrode 108 is disposed in the first trench V1 and located between the gate 104 and the P-type column region 1022, the gate insulating film 107 is spaced between the electrode 108 and the gate 104, and the electrode 108 is electrically connected to the source 105. The semiconductor layer 103 may include a first semiconductor region (P+) 1034 located at the bottom of the first trench V1, and a P-well (P) 1031, a source region (N+) 1032, and a second semiconductor region (N) 1033 that are located on a side wall of the first trench V1. The first semiconductor region 1034 is a P-type semiconductor region, the second semiconductor region 1033 is an N-type semiconductor region, the source region 1032 is located above the P-well 1031, the second semiconductor region 1033 is located between the P-well 1031 and the N-type column region 1021, the first semiconductor region 1034 is located between the electrode 108 and the P-type column region 1022, and the first semiconductor region 1034 is in contact with the electrode 108 and the P-type column region 1022, a doping density of the first semiconductor region 1034 is higher than a doping density of the P-type column region 1022, and the first semiconductor region 1034 is used to electrically connect the electrode 108 to the P-type column region 1022. The source 105 is disposed above the semiconductor layer 103, and the source 105 is in contact with the source region 1032 and electrically connected to the electrode 108. The drain 106 is disposed on a side that is of the semiconductor substrate 101 that is away from the drift layer 102.

According to the semiconductor device provided in this embodiment of this application, the electrode 108 is disposed below the gate 104, the P-type first semiconductor region 1034 is disposed at the bottom of the first trench V1, the first semiconductor region 1034 is in contact with the electrode 108 and the P-type column region 1022 located below the gate 104, and the electrode 108 is electrically connected to the source 105. In this way, the P-type column region 1022 located below the gate 104 may be connected to the source 105 through the electrode 108, and good electrical contact is implemented between the electrode 108 and the first semiconductor region 1034, thereby implementing a grounding function. In addition, because both the electrode 108 and the first semiconductor region 1034 are located below the gate 104, compared with the related technology, this does not sacrifice the MOS conductive channel on the side wall of the first trench V1, that is, the conductive channel is added, so that the on resistance of the device can be reduced. In addition, the grounded electrode 108 can shield a gate-drain capacitance, thereby reducing a Miller capacitance of the device and improving a switching speed. In addition, the grounded electrode 108 can further effectively reduce an electric field in the gate insulating film 107 located at the bottom of the first trench V1, thereby improving working robustness of the device.

Specifically, in this application, because the electrode 108 is located between the gate 104 and the drain 106, it is equivalent to inserting the grounded electrode 108 into the middle of a parallel plate capacitor (a gate-drain capacitor), so that all electric field lines emitted by the gate 104 and the drain 106 are terminated on the middle grounded electrode 108, that is, the electrode 108 shields the original gate-drain capacitance. When the gate-drain capacitance is shielded, the Miller capacitance (mainly the gate-drain capacitance) is reduced. Because a switching process of a device is essentially a capacitor charging and discharging process, the switching speed is improved when the capacitance is reduced.

In actual application, there is a high electric field in the drift region of the SiC MOSFET in the blocking state. According to the principle of continuous potential displacement vector, electric field lines will enter the gate insulating film. However, because of a curvature effect at the bottom of the first trench V1, an electric field at the bottom of the first trench V1 is particularly concentrated, and consequently, an electric field of the gate insulating film 107 at the bottom of the first trench V1 is extremely high. Long-term high electric field stress will cause quality degradation of the gate insulating film 107 and a reliability failure of the device. However, in the semiconductor device provided in this application, the grounded electrode 108 is located below the gate insulating film 107, and a zero potential of the grounded electrode 108 causes most electric field lines to terminate at the electrode 108, thereby reducing electric field lines that enter the gate insulating film 107. Therefore, an electric field in the gate insulating film 107 at the bottom of the first trench V1 can be effectively reduced, and long-term working reliability (robustness) of the device is improved.

A thickness of the electrode is not limited in this application, and may be set based on a requirement of the device.

In this application, a material of the electrode may be heavily doped polycrystalline silicon, or may be another material having a good conductive feature, such as metal. This is not limited herein.

In this application, the semiconductor substrate may be a silicon carbide single crystal substrate doped with a 5-valence element. The drift layer may be formed in a manner of forming a P-type column region through ion injection in the N-type semiconductor layer. An ion injection depth of the P-type column region may be less than a thickness of the N-type semiconductor layer, and a region between adj acent P-type column regions is an N-type column region. In the drift layer, the doping density of the N-type column region is generally lower than the doping density of the semiconductor substrate.

In this application, the first semiconductor region (P+), the P-well, the source region (N+), the second semiconductor region (N), and the third semiconductor region (P++), the fourth semiconductor region (P+), and the fifth semiconductor region (P+) that are located in the semiconductor layer may be formed by doping the semiconductor layer. The source region (N+) is an N-type semiconductor region, the P-well is a P-type semiconductor region, the N-type semiconductor region is mainly doped with an N-type impurity such as nitrogen (N), phosphorus (P), or arsenic (As), and the P-type semiconductor region is mainly doped with a P-type impurity such as aluminum (Al), boron (B), or gallium (Ga). The P-well is a P-type impurity that is doped in the N-type semiconductor layer with sufficient density to neutralize the N-type semiconductor layer and allow the N-type semiconductor layer to have a P-type feature.

It should be noted that, in this application, a comparison between doping densities of two regions is merely a comparison between densities of impurities doped in the two regions; and neither a component of the impurity nor a substrate used for doping the impurity is limited, that is, the components of the impurity may be the same or may be different, and materials of the substrate used for doping the impurity may be the same or may be different.

In this application, for various N-type semiconductor regions such as a semiconductor substrate (N++), an N-type column region (N), a second semiconductor region (N), and a source region (N+), generally, the doping density of the semiconductor substrate (N++) is the highest, the doping density of the source region (N+) is the second highest, and the doping densities of the N-type column region (N) and the second semiconductor region (N) are the lowest. The doping densities of the N-type column region (N) and the second semiconductor region (N) are similar, but are not limited to the same doping density. For example, to reduce the on resistance of the SiC MOSFET, the doping density of the second semiconductor region (N) is generally higher than the doping density of the N-type column region (N).

In this application, for various P-type semiconductor regions such as a P-type column region (P), a first semiconductor region (P+), and a P-well (P), generally, the doping density of the first semiconductor region (P+) is higher than the doping densities of the P-type column region (P) and the P-well (P). The doping densities of the P-type column region (P) and the P-well (P) are similar, but are not limited to the same doping density.

According to the semiconductor device provided in this embodiment of this application, the electrode 108 is mainly disposed for the P-type column region located below the gate 104. During specific implementation, in the drift layer 102, only a part of the P-type column region 1022 is located below the gate 104, and another part of the P-type column regions 1022 is not disposed below the gate 104. The part that is of the P-type column region 1022 and that is located below the gate 104 is the first P-type column region 1022a, and the remaining part of the P-type column region 1022 is the second P-type column region 1022b. A manner of electrically connecting the second P-type column region 1022b to the source 105 is not limited in this application.

Still refer to FIG. 3. The semiconductor device may further include a third semiconductor region (P++) 1035. The third semiconductor region 1035 is a P-type semiconductor region, and is disposed in the semiconductor layer 103 and located between the second P-type column region 1022b and the source 105; the third semiconductor region 1035 is in contact with the source 105 and the second P-type column region 1022b; and a doping density of the third semiconductor region 1035 is higher than a doping density of the second P-type column region 1022b. In this way, the second P-type column region 1022b is electrically connected to the source 105 through the third semiconductor region 1035.

During specific implementation, to enable the third semiconductor region 1035 in the semiconductor layer 103 to be in contact with both the second P-type column region 1022b and the source 105, a thickness of the third semiconductor region 1035 needs to be the same as a thickness of the semiconductor layer 103, and consequently, a process difficulty of the third semiconductor region 1035 is increased.

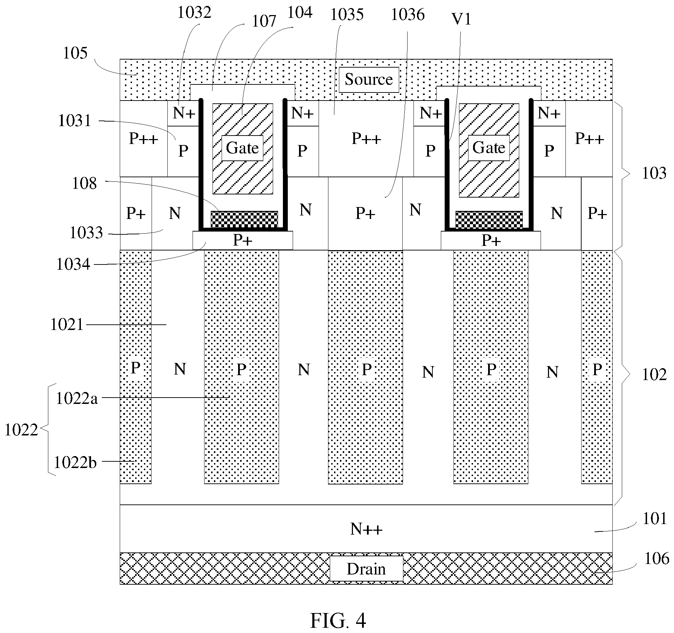

Therefore, optionally, to reduce the process difficulty, in an embodiment, refer to FIG. 4. FIG. 4 is a schematic diagram of a structure of a semiconductor device according to still another embodiment of this application. The semiconductor device may further include a fourth semiconductor region (P+) 1036. The fourth semiconductor region 1036 is a P-type semiconductor region, and is disposed in the semiconductor layer 103 and located between the second P-type column region 1022b and the third semiconductor region 1035; the fourth semiconductor region 1036 is in contact with the third semiconductor region 1035 and the second P-type column region 1022b; and a doping density of the fourth semiconductor region 1036 is lower than a doping density of the third semiconductor region 1035 and higher than a doping density of the P-type column region 1022. In this way, during preparation, the fourth semiconductor region 1036 may be first formed, and then the third semiconductor region 1035 is formed, so that process difficulty is reduced.

During specific implementation, the doping density of the fourth semiconductor region 1036 may be close to the doping density of the first semiconductor region 1034, but is not limited to the same doping density.

For example, the doping density of the fourth semiconductor region 1036 is the same as the doping density of the first semiconductor region 1034. In this way, during preparation, the fourth semiconductor region 1036 and the first semiconductor region 1034 may be prepared at the same time, thereby simplifying process steps

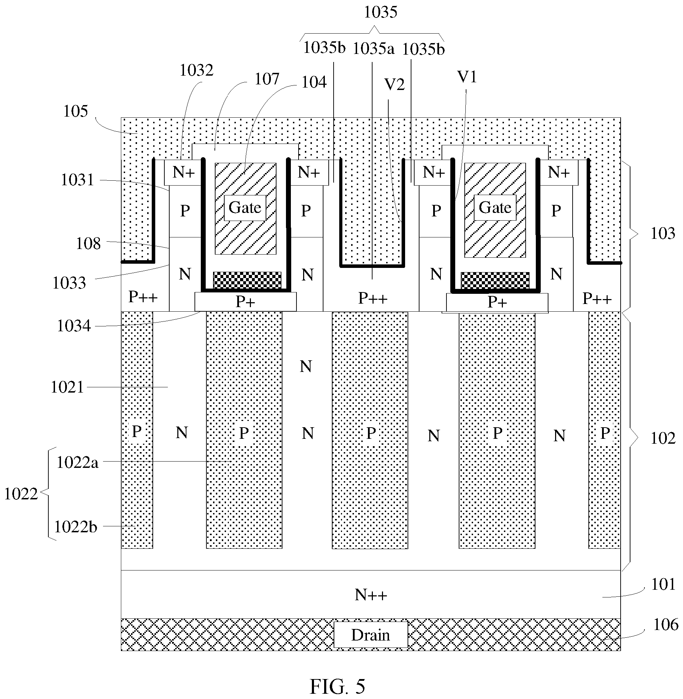

In another embodiment, refer to FIG. 5. FIG. 5 is a schematic diagram of a structure of a semiconductor device according to still another embodiment of this application. The semiconductor device further includes a second trench V2 disposed in the semiconductor layer 103, the second trench V2 is filled with the source 105, and the third semiconductor region 1035 includes a first extension part 1035a at the bottom of the second trench V2 and a second extension part 1035b located on a side wall of the second trench V2. In this way, the thickness of the third semiconductor region 1035 can be reduced by disposing the second trench V2, so that the process difficulty can be reduced.

In this application, refer to FIG. 3 to FIG. 5. A P-well 1031 and a source region 1032 are disposed on both sides of the gate 104, to ensure that MOS conductive channels exist on both sides of the gate of the SiC MOSFET.

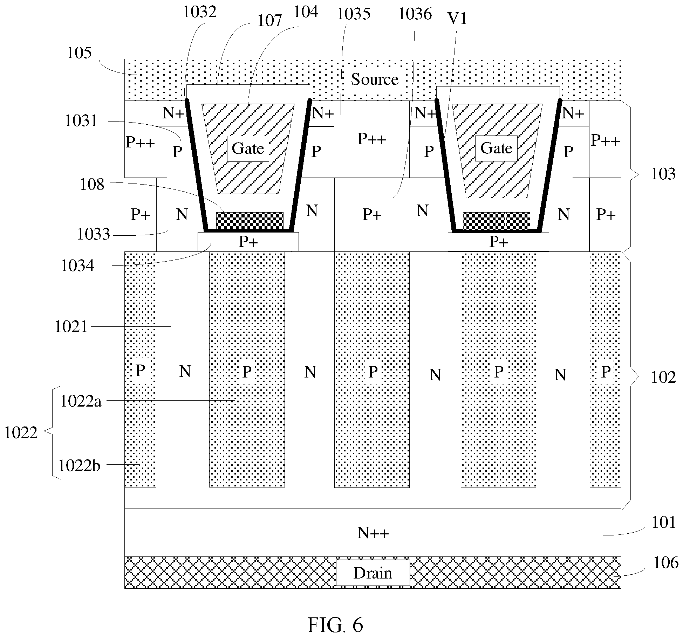

A shape of the first trench is not limited in this application. For example, as shown in FIG. 3 to FIG. 5, a cross section of the first trench V1 in a direction perpendicular to the semiconductor substrate 101 is rectangular, or as shown in FIG. 6, a cross section of the first trench V1 in a direction perpendicular to the semiconductor substrate 101 is trapezoidal, and a longer distance between a cross section of the first trench V1 in a direction parallel to the semiconductor substrate 101 and the semiconductor substrate 101 indicates a larger area of the cross section, that is, an area of a top surface (a cross section located on a side far away from the semiconductor substrate 101) of the first trench V1 is larger than an area of a bottom surface (a cross section located on a side close to the semiconductor substrate 101) of the first trench V1.

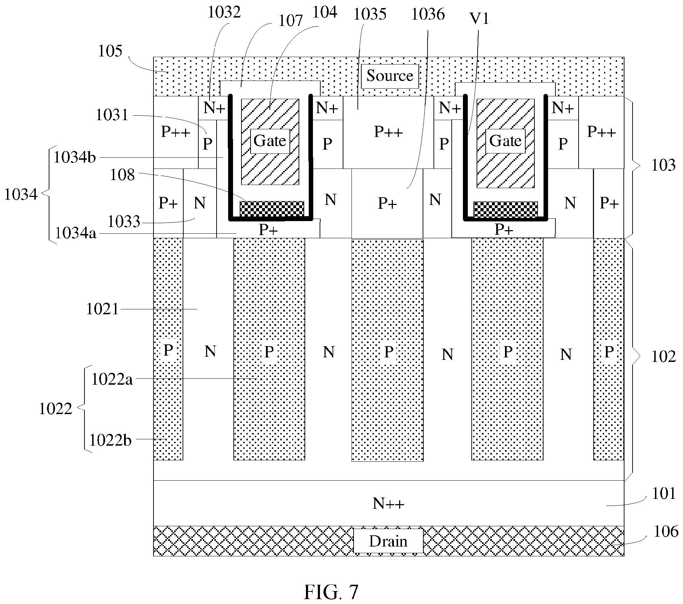

To improve electrical contact between the electrode 108 and the first P-type column region 1022a, refer to FIG. 7. FIG. 7 is a schematic diagram of a structure of a semiconductor device according to still another embodiment of this application. The first semiconductor region 1034 may include a first extension part 1034a at the bottom of the first trench V1 and a second extension part 1034b on a side wall on one side of the first trench V1. In this way, when the semiconductor device includes a plurality of gates, a part of the first semiconductor region 1034 may be set to include the first extension part 1034a and the second extension part 1034b, that is, only a MOS conductive channel on one side of each of some gates is sacrificed. Compared with the related technology in which a MOS conductive channel on one side of each gate needs to be sacrificed, this improves electrical contact between the electrode 108 and the first P-type column region 1022a, and reduces the on resistance of the semiconductor device.

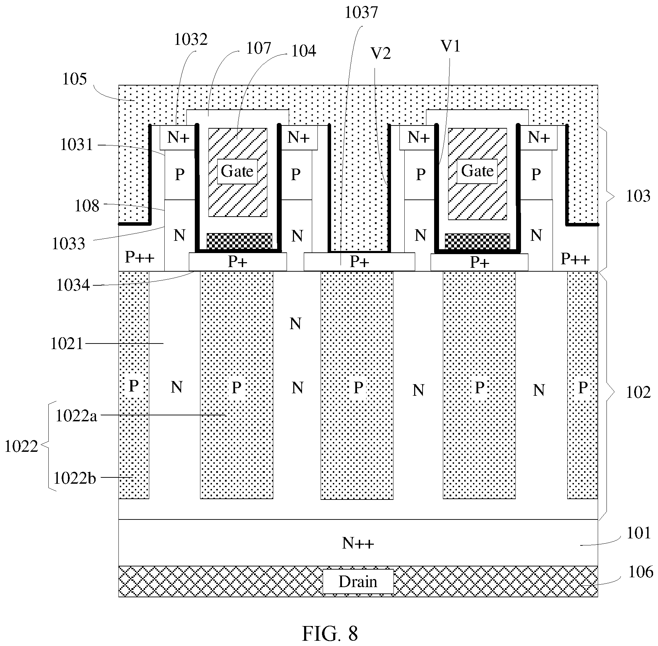

During specific implementation, in the semiconductor device provided in this embodiment of this application, the semiconductor layer 103 may include a plurality of first trenches V1. To improve electrical contact between the electrode 108 and the first P-type column region 1022a, as shown in FIG. 8, the semiconductor layer 103 further includes at least one second trench V2, and the second trench V2 is located between two adjacent first trenches V1. The semiconductor layer 103 further includes a P-type fifth semiconductor region (P+) 1037 located at the bottom of the second trench V2, and a doping density of the fifth semiconductor region 1037 is higher than a doping density of the P-type column region 1022. The fifth semiconductor region 1037 is in contact with the source 105 and the P-type column region 1022.

During specific implementation, the doping density of the fifth semiconductor region may be close to the doping density of the first semiconductor region, but is not limited to the same doping density.

For example, the doping density of the fifth semiconductor region is the same as the doping density of the first semiconductor region. In this way, during preparation, the fifth semiconductor region and the first semiconductor region may be prepared at the same time, thereby simplifying process steps.

During specific implementation, the second trench may be disposed only between some adjacent first trenches.

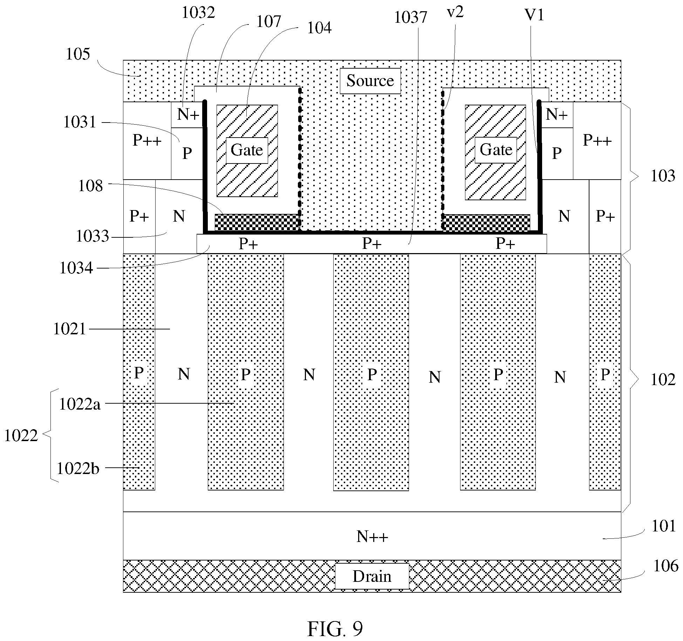

For example, as shown in FIG. 9, the fifth semiconductor region 1037 is connected to the first semiconductor region 1034 adjacent to the fifth semiconductor region 1037, that is, the fifth semiconductor region 1037 and the first semiconductor region 1034 are of an integrated structure.

Further, to increase a contact area between the source 104 and the fifth semiconductor region 1037, the second trench V2 is connected to two first trenches V1 adjacent to the second trench V2. That is, it is equivalent to connecting two adjacent first trenches V1 and the second trench located V2 between the two adjacent first trenches V1, so that the two gates 104 and a part of the source 105 are disposed in a same trench, where the gate 104 and the source 105 are isolated by a gate insulating film 107.

Correspondingly, an embodiment of this application further provides an integrated circuit. The integrated circuit may include a circuit board and any semiconductor device provided in the foregoing embodiments of this application. The semiconductor device is disposed on the circuit board. A problem-resolving principle of the electronic circuit is similar to that of the foregoing semiconductor device. Therefore, for implementation of the electronic circuit, refer to the implementation of the foregoing semiconductor device. Details are not described again.

Apparently, a person skilled in the art can make various modifications and variations to this application without departing from the spirit and scope of this application. This application is intended to cover these modifications and variations of this application provided that they fall within the protection scope defined by the following claims and their equivalent technologies.

## Claims

1. A semiconductor device, comprising:
an N-type semiconductor substrate;
a drift layer, wherein the drift layer is disposed on the semiconductor substrate, and the drift layer comprises an N-type column region and a P-type column region that are alternately and repeatedly disposed in parallel;
a semiconductor layer, wherein the semiconductor layer is disposed above the drift layer;
a first trench, wherein the first trench is disposed in the semiconductor layer, and is disposed in a region corresponding to the P-type column region;
a gate, wherein the gate is disposed in the first trench and separated by a gate insulating film;
an electrode, wherein the electrode is disposed in the first trench and located between the gate and the P-type column region, and the gate insulating film is spaced between the electrode and the gate;
a first semiconductor region, wherein the first semiconductor region is a P-type semiconductor region, the first semiconductor region is disposed in the semiconductor layer, is located between the electrode and the P-type column region, and is in contact with the electrode and the P-type column region, and a doping density of the first semiconductor region is higher than a doping density of the P-type column region;
a P-well, wherein the P-well is disposed in the semiconductor layer and located on a side wall of the first trench;
a source region, wherein the source region is disposed in the semiconductor layer and located above the P-well;
a second semiconductor region, wherein the second semiconductor region is an N-type semiconductor region, and the second semiconductor region is disposed in the semiconductor layer and located between the P-well and the N-type column region;
a source, wherein the source is disposed above the semiconductor layer, and the source is in contact with the source region and electrically connected to the electrode; and
a drain, wherein the drain is disposed on a side that is of the semiconductor substrate and that is away from the drift layer.

2. The semiconductor device according to claim 1, wherein a part that is of the P-type column region and that is located below the gate is a first P-type column region, and another part of the P-type column regions is a second P-type column region; and
the semiconductor device further comprises:
a third semiconductor region, wherein the third semiconductor region is a P-type semiconductor region, and the third semiconductor region is disposed in the semiconductor layer and located between the second P-type column region and the source;
the third semiconductor region is in contact with the source and the second P-type column region; and
a doping density of the third semiconductor region is higher than a doping density of the second P-type column region.

3. The semiconductor device according to claim 2, wherein the semiconductor device further comprises:
a fourth semiconductor region, wherein the fourth semiconductor region is a P-type semiconductor region, the fourth semiconductor region is disposed in the semiconductor layer and located between the second P-type column region and the third semiconductor region;
the fourth semiconductor region is in contact with the third semiconductor region and the second P-type column region; and
a doping density of the fourth semiconductor region is lower than the doping density of the third semiconductor region and higher than the doping density of the P-type column region.

4. The semiconductor device according to claim 3, wherein the doping density of the fourth semiconductor region is the same as the doping density of the first semiconductor region.

5. The semiconductor device according to claim 2, wherein the semiconductor device further comprises a second trench disposed in the semiconductor layer, and the second trench is filled with the source; and
the third semiconductor region comprises a first extension part located at the bottom of the second trench and a second extension part located on a side wall of the second trench.

6. The semiconductor device according to any one of claims 1 to 5, wherein a cross section of the first trench is trapezoidal in a direction perpendicular to the semiconductor substrate, and a longer distance between the cross section of the first trench in a direction parallel to the semiconductor substrate and the semiconductor substrate indicates a larger area of the cross section of the first trench in the direction parallel to the semiconductor substrate.

7. The semiconductor device according to any one of claims 1 to 6, wherein the first semiconductor region comprises a first extension part located at the bottom of the first trench and a second extension part located on a side wall on one side of the first trench.

8. The semiconductor device according to claim 1, wherein the semiconductor layer comprises a plurality of first trenches; and the semiconductor layer further comprises at least one second trench, and the second trench is located between two adjacent first trenches;
the semiconductor layer further comprises a fifth semiconductor region located at the bottom of the second trench, the fifth semiconductor region is a P-type semiconductor region, and a doping density of the fifth semiconductor region is higher than the doping density of the P-type column region; and
the fifth semiconductor region is in contact with the source and the P-type column region.

9. The semiconductor device according to claim 8, wherein the second trench is connected to two first trenches adjacent to the second trench.

10. The semiconductor device according to claim 8 or 9, wherein the doping density of the fifth semiconductor region is the same as the doping density of the first semiconductor region.

11. The semiconductor device according to claim 10, wherein the fifth semiconductor region and the first semiconductor region adjacent to the fifth semiconductor region are of an integrated structure.

12. An integrated circuit, comprising a circuit board and the semiconductor device according to any one of claims 1 to 11 that is disposed on the circuit board.
